# EUROPÄISCHE PATENTSCHRIFT

(11) **EP 0 508 977 B1**
(45) Veröffentlichungstag und Bekanntmachung des Hinweises auf die Patenterteilung: **11.01.1995**
(21) Anmeldenummer: 92890081.0
(22) Anmeldetag: 06.04.1992
(51) Int. Cl.: H05K 3/34, H05K 13/00, F16B 5/06, F16B 2/24

(54) **Klips zum Verbinden zweier plattenförmiger Elemente**
Clip to connect two plate-like elements
Clip pour unir deux éléments en forme de plaquette

(30) Priorität: 09.04.1991 AT 745/91
(43) Veröffentlichungstag der Anmeldung: 14.10.1992
(73) Patentinhaber: ISOVOLTA Österreichische Isolierstoffwerke Aktiengesellschaft, 2355 Wiener Neudorf (AT)
(72) Erfinder: Pfaffenbichler, Peter Dipl.-Ing., A-1170 Wien (AT)

(56) Entgegenhaltungen:
- EP-A- 0 256 384
- GB-A- 2 209 368
- US-A- 4 759 488

## Beschreibung

Die Erfindung betrifft einen Klips zum Verbinden zweier plattenförmiger Elemente an ihren Kantenregionen, hergestellt aus einem mit zumindest einem Durchbruch versehenen, zum Klips gebogenen Blechzuschnitt, bestehend asu einem ebenen, ein oder mehrere vorstehende zungenförmige Anschläge aufweisenden Basisbereich, der über zwei Verbindungssstege an einen Federbereich anschließt, derart, daß Basisbereich und Federbereich an der Unter- bzw. Oberseite der Kantenregion eines der plattenförmigen Elemente anliegen, und einer gebogenen Federzunge, die von der Kontur eines Durchbruchs im Federbereich des Klipses ausgehend mit ihrem freien Ende bis knapp an die Anschläge hinunterreicht und zusammen mit diesen Anschlägen zur federnden Halterung der Kantenregion des anderen plattenförmigen Elementes dient. Sie betrifft ferner eine vorteilhafte Verwendung eines solchen Klips.

Bekannte Klipse der vorstehenden Art dienen insbesondere als Verbindungselemente zwischen Lötrahmen und den in Ausschnitten von diesen aufgenommenen Leiterplatten, die mit elektronischen Bauelementen bestückt sind, deren Anschlüsse durch ein Schwallötverfahren verlötet werden sollen. Dazu werden die Lötrahmen mit den Leiterplatten z.B: mittels eines Kettentransporteurs über dem Lötbad vorbeigeführt. Die Unterseiten der Leiterplatten treten dann mit dem Lötbad in Kontakt, wobei das Lot in die Bohrungen für die Anschlüsse eindringt und somit die Verlötung erfolgt.

Bei der Verwendung der vorstehend genannten, bekannten Klipse sind diese am Rand des Ausschnittes des Lötrahmens befestigt, wobei die zungenförmigen Anschläge in der Höhe der Unterseite des Lötrahmens in den Raum des Ausschnittes hineinreichen. Zum Beladen der Lötrahmen mit den Leiterplatten werden diese von oben in die Ausschnitte hineingedrückt, so daß sie schließlich an ihren Rändern auf den zungenförmigen Anschlägen der Klipse aufliegen. Die freien Enden der gebogenen Federzungen der Klipse halten die Leiterplatten an ihren Rändern elastisch fest. Zum Entladen der Leiterplatten werden diese einfach nach oben gestoßen, wobei die elastisch nachgebenden Federzungen die Leiterplatten freigeben.

Lötrahmen und Klipse müssen aus Materialien bestehen, die von dem verwendeten Lot nicht benetzt werden. Für die Lötrahmen werden beispielsweise GFK-Laminate auf Epoxyharzbasis verwendet; die Klipse werden meistens aus Titanblech hergestellt. Bei den vorstehend genannten, bekannten Klipsen ist es notwendig, daß die Leiterplatten eine genau einzuhaltende Dicke mit einer Toleranz von z.B. 4 ± 0,1 mm aufweisen. Herstellungsbedingt ist jedoch bei GFK-Laminaten auf Epoxyharzbasis nach DIN 7735 eine Dickentoleranz von z.B. 4 mm ± 0,45 mm (DIN 40606) gestattet. Zur Verwendung als Lötrahmen in Zusammenhang mit den genannten bekannten Klipsen müssen diese GFK-Laminate auf das vorgeschriebene Dickenmaß geschliffen werden. Durch das Anschleifen wird aber die Glasfaserverstärkung verletzt; es entstehen an der geschliffenen Oberfläche feine Zerklüftungen, die den Lötrahmen gegen die korrosive Wirkung von Chemikalien anfälliger machen und dadurch seine Standzeit verkürzen.

Der Erfindung liegt nun die Aufgabe zugrunde, Klipse der eingangs erwähnten Art anzugeben, die an den Kantenregionen von plattenförmigen Elementen, wie an den Kantenregionen von Ausschnitten von Lötrahmen im wesentlichen unverrückbar angebracht werden können, wobei die plattenförmigen Elemente eine relativ hohe Dickentoleranz aufweisen können.

Diese Aufgabe wird durch den in Anspruch 1 angegebenen erfindungsgemäßen Klips gelöst.

Dabei sind vorzugsweise die beiden Stege im Federbereich im Mittel schmäler als die beiden Verbindungsstege.

In einer vorteilhaften Ausgestaltung des erfindungsgemäßen Klips ist der Federbereich in einem mittleren Abschnitt zur Oberfläche des plattenförmigen Elementes hin gebogen.

Die Erfindung wird nachstehend anhand der Figuren eingehend erläutert.

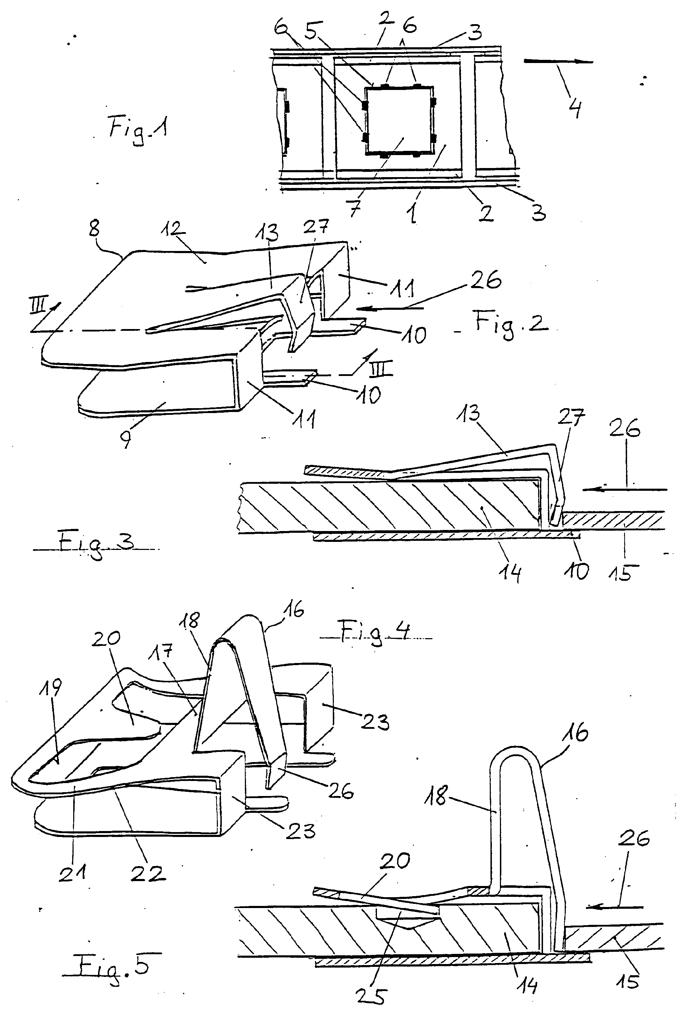

Fig. 1 zeigt einen Lötrahmen 1, der über Halterungen 2 von einem Kettentransporteur 3 in Richtung des Pfeiles 4 bewegt wird. In einem Ausschnitt 5 des Lötrahmens ist mithilfe von Verbindungselementen 6 eine Leiterplatte 7 angebracht, die einem Schwallötprozeß unterworfen werden soll.

In den Figuren 2 und 3 ist ein solches Verbindungselement 6 in Form des eingangs der Beschreibung erwähnten Klips 8 in perspektivischer Darstellung, beziehungsweise - im applizierten Zustand - zusammen mit einer Teildarstellung von Lötrahmen und Leiterplatte im Schnitt gezeigt. Der Klips 8 wird aus einem Zuschnitt aus Titanblech einer Dicke von 0,4 bis 1 mm hergestellt. Er weist einen ebenen Basisbereich 9 auf, der an der Unterseite der Kantenregion des Lötrahmens anliegt (Fig. 3). In Forsetzung dieses Basisbereiches 9 sind zwei zungenförmige Anschläge 10 vorgesehen. Der Basisbereich 9 schließt über zwei rechtwinkelig abgebogene Verbindungsstege 11 an einen Federbereich 12 an, der an der Oberseite der Kantenregion federnd anliegt (Fig. 3). Der zur Herstellung des Klips 8 dienende Blechzuschnitt weist einen Durchbruch auf, von dessen Kontur die beiden Anschläge 10 und eine gebogene Federzunge 13 ausgehen, wobei letztere mit ihrem freien Ende bis an das Niveau der Anschläge 10 hinunterreicht.

Aus Fig. 3, die eine Schnittdarstellung längs der Linie III-III in Fig. 2 darstellt, erkennt man den Klips 8 montiert an der Kantenregion 14 des Lötrahmens 1 und die Kantenregion 15 einer Leiterplatte 7, die auf den Anschlägen 10 aufliegt und von der Federzunge 13 elastisch festgehalten wird.

Ein Nachteil dieses bekannten Klips 8 besteht darin, daß das plattenförmige Material des Lötrahmens, an dessen Kantenregion er aufgesteckt wird, eine genau vorbestimmte Dicke aufweisen muß. Ferner reicht die Anpreßkraft des Federbereiches 12 meist nicht aus, um ein Verschieben des Klips zu verhindern.

Die Figuren 4 und 5 zeigen nun eine bevorzugte Ausführungsform des erfinderischen Klips beziehungsweise seiner Applikation in zu den Figuren 2 und 3 analogen Darstellungen. Bei dem erfinderischen Klips ist die Federzunge U-förmig ausgebildet und weist einen an den Federbereich 17 anschließenden, aufsteigenden Schenkel 18 auf, der mit dem Federbereich 17 einen Winkel von ca. 80° einschließt. Im Federbereich 17 ist ferner ein zweiter Durchbruch vorgesehen, von dessen Kontur 19 ein in Richtung der Federzunge 16 weisender Verrieglungsfortsatz 20 ausgeht, der leicht zur Lötrahmenoberfläche hin gebogen ist. Die Stege 21 weisen im Mittel eine kleinere Breite auf als die Verbindungsstege 23. Innerhalb eines von den Stegen 22 eingenommenen mittleren Abschnittes 24 ist der Federbereich 17 leicht zur Oberfläche des Lötrahmens hin gebogen.

Beim Aufstecken des Klips verformt sich der Federbereich 17 hauptsächlich innerhalb der Stege 22 derart, daß man die Anpreßkraft des Federbereichs 17 durch entsprechende Wahl der Breite der Stege 22 einstellen kann. Aufgrund seiner besonderen Form kann der erfinderische Klips auf Lötrahmen, die z.B. bei 4 mm Dicken-Nennmaß eine Dicke von 3,55 bis 4,45 mm haben, aufgesteckt werden.

Der Verriegelungsfortsatz 20 drückt gegen die Lötrahmenoberfläche, was schon bei einer etwas rauhen Oberflächenstruktur meist ein ungewünschtes Verrücken des Klips verhindert. Wenn erforderlich kann z.B. in der Lötrahmenoberfläche ein Sackloch 25 (Fig. 5) angebracht werden, in das der Verriegelungsforsatz 21 einrastet.

Die U-förmige Federzunge 16 des erfindungsgemäßen Klips hat noch folgenden Vorteil. Während bei dem bekannten Klips gemäß den Figuren 2 und 3 bei der Belastung der Federzunge 13 beim Einsetzen einer Leiterplatte in den Lötrahmen in Richtung des Pfeiles 26 praktisch nur der abgewinkelte Federzungenbereich 27 federnd verformt wird, was zu einer relativ steifen Federung führt, wird bei dem erfindungsgemäßen Klips (Fig. 4 und 5) bei einer solchen Belastung in Richtung des Pfeiles 26 die U-förmige Federzunge 16 praktisch über ihre ganze Länge an der elastischen Verformung beteiligt, was letztlich eine optimale Auslegung der Federung ermöglicht.

## Patentansprüche

1. Klips zum Verbinden zweier plattenförmiger Elemente an ihren Kantenregionen, hergestellt aus einem mit zumindest einem Durchbruch versehenen, zum Klips gebogenen Blechzuschnitt, bestehend aus einem ebenen, ein oder mehrere vorstehende zungenförmige Anschläge aufweisenden Basisbereich, der über zwei Verbindungssstege an einen Federbereich anschließt, derart, daß Basisbereich und Federbereich an der Unter- bzw. Oberseite der Kantenregion eines der plattenförmigen Elemente anliegen, und einer gebogenen Federzunge, die von der Kontur eines Durchbruchs im Federbereich des Klipses ausgehend mit ihrem freien Ende bis knapp an die Anschläge hinunterreicht und zusammen mit diesen Anschlägen zur federnden Halterung der Kantenregion des anderen plattenförmigen Elementes dient, dadurch gekennzeichnet, daß die Federzunge (16) im wesentlichen U-förmig ausgebildet ist und ihr an den Federbereich (17) anschließender, aufsteigender Schenkel (18) um einen Winkel von mindestens 60°, vorteilhaft jedoch von mindestens 75°, aus der Ebene des Federbereichs (17) herausgebogen ist und daß der Federbereich (17) einen weiteren Druchbruch aufweist, von dessen Kontur (19) ein in Richtung auf die Federzunge (16) weisender, leicht zur Elementoberfläche gebogener Verriegelungsfortsatz (20) ausgeht.

2. Klips nach Anspruch 1, dadurch gekennzeichnet, daß die Stege (21) im Federbereich (17) im Mittel schmäler sind als die beiden an den Federbereich (17) anschließenden Verbindungsstege (23).

3. Klips nach Anspruch 1 oder 2, dadurch gekennzeichnet, daß der Federbereich (17) in einem mittleren Abschnitt zur Oberfläche des plattenförmigen Elementes hin gebogen ist.

4. Verwendung eines Klips nach einem der Ansprüche 1 bis 3, dadurch gekennzeichnet, daß er zum Verbinden eines Lötrahmens (1) und einer Leiterplatte (7) als plattenförmige Elemente dient.

## Claims

1. A clip for connecting two sheet-like elements at their edge regions, produced from a blank of sheet material provided with at least one opening and bent to form the clip, comprising a flat base zone which has one or more projecting, tab-like lugs and which adjoins a spring zone via two connecting webs in such a way that the base zone and spring zone adjoin the underside and upper side respectively of the edge region of one of the sheet-like elements, and a bent spring tongue which, starting from the contour of an opening in the spring zone of the clip, extends at its free end almost down to the lugs and together with these lugs serves for the resilient mounting of the edge region of the other sheet-like element, characterised in that the spring tongue (16) is substantially U-shaped and its ascending limb (18) adjoining the spring zone (17) is bent by an angle of at least 60°, but preferably of at least 75°, from the plane of the spring zone (17), and in that the spring zone (17) has a further opening from the contour (19) of which extends a locking extension (20) facing towards the spring tongue (16) and bent slightly towards the surface of the element.

2. A clip according to Claim 1, characterised in that the webs (21) in the spring zone (17) are on average narrower than the two connecting webs (23) adjoining the spring zone (17).

3. A clip according to Claim 1 or 2, characterised in that in a central portion the spring zone (17) is bent towards the surface of the sheet-like element.

4. A clip according to any one of Claims 1 to 3, characterised in that it is used for connecting a soldering frame (1) and a circuit board (7) as the sheet-like elements.

## Revendications

1. Pince pour relier deux éléments en forme de plaque au niveau de leurs zones d'arête, fabriquée à partir d'un flan de tôle, replié pour former une pince et muni d'au moins un passage, composée d'une zone de base plane, présentant une ou plusieurs butées en saillie en forme de languette, et se raccordant, par l'intermédiaire de deux nervures de liaison, à une zone de ressort de telle sorte que la zone de base et la zone de ressort s'appuient respectivement, sur la face inférieure ou supérieure de la zone d'arête de l'un des éléments en forme de plaque, et d'une languette de ressort repliée, qui, en partant du contour d'un passage ménagé dans la zone de ressort de la pince, atteint, par son extrémité libre, juste les butées et sert, conjointement avec ces butées, à assurer une fixation élastique de la zone d'arête de l'autre élément en forme de plaque, caractérisée en ce que la languette de ressort (16) est réalisée sensiblement en forme de U et en ce que sa branche montante (18) se raccordant à la zone de ressort (17), est repliée suivant un angle d'au moins 60°, avantageusement cependant d'au moins 75°, par rapport au plan de la zone de ressort (17) et en ce que la zone de ressort (17) présente un passage supplémentaire, du contour (19) duquel part un prolongement de verrouillage (20), légèrement replié par rapport à la surface de l'élément et orienté en direction de la languette de ressort (16).

2. Pince selon la revendication 1 caractérisée en ce que les nervures (21) de la zone de ressort (17) sont plus étroites en partie médiane, que les deux nervures de liaison (23) se raccordant à la zone de ressort (17).

3. Pince selon la revendication 1 ou 2, caractérisée en ce que la zone de ressort (17) est repliée dans un tronçon médian vers la surface supérieure de l'élément en forme de plaque.

4. Utilisation d'une pince selon l'une des revendications 1 à 3, caractérisée en ce qu'elle sert à relier un cadre à souder ou à braser (1) et une plaquette à circuit imprimé (7), comme éléments en forme de plaque.
